# FASCICULE DE BREVET EUROPEEN

(11) **EP 3 355 118 B1**
(45) Date de publication et mention de la délivrance du brevet: **23.10.2019**
(21) Numéro de dépôt: 18153558.4
(22) Date de dépôt: 26.01.2018
(51) Int. Cl.: G03F 7/20, G03F 1/78

(54) **PROCÉDÉ DE MESURE DU DÉSALIGNEMENT ENTRE UNE PREMIÈRE ET UNE SECONDE ZONES DE GRAVURE**
VERFAHREN ZUM MESSEN DES VERSATZES ZWISCHEN EINER ERSTEN UND EINER ZWEITEN GRAVURZONE
METHOD FOR MEASURING THE MISALIGNMENT BETWEEN FIRST AND SECOND ETCHING AREAS

(30) Priorité: 30.01.2017 FR 1750759
(43) Date de publication de la demande: 01.08.2018
(73) Titulaire: COMMISSARIAT À L'ÉNERGIE ATOMIQUE ET AUX ÉNERGIES ALTERNATIVES, 75015 Paris (FR)
(72) Inventeur: RADEMAKER, Guido, 38000 GRENOBLE (FR); BOUTAMI, Salim, 38100 GRENOBLE (FR); PRADELLES, Jonathan, 38410 SAINT-MARTIN-D'URIAGE (FR)
(74) Mandataire: Colombo, Michel

(56) Documents cités:
- US-A1- 2011 229 010
- US-A1- 2014 132 948
- US-A1- 2014 211 195
- US-A1- 2015 198 524
- GREIBE TINE ET AL: "Quality control of JEOL JBX-9500FSZ e-beam lithography system in a multi-user laboratory", MICROELECTRONIC ENGINEERING, ELSEVIER PUBLISHERS BV., AMSTERDAM, NL, vol. 155, 16 février 2016 (2016-02-16), pages 25-28, XP029562503, ISSN: 0167-9317, DOI: 10.1016/J.MEE.2016.02.003
- SMOLYANINOV ALEXEI ET AL: "Meta-coaxial nanoantenna", 2014 CONFERENCE ON LASERS AND ELECTRO-OPTICS (CLEO) - LASER SCIENCE TO PHOTONIC APPLICATIONS, THE OPTICAL SOCIETY, 8 juin 2014 (2014-06-08), pages 1-2, XP032707605, DOI: 10.1364/CLEO_QELS.2014.FM2K.2

## Description

L'invention concerne un procédé de mesure du désalignement entre une première et une seconde zones de gravure. Elle a également pour objet un support d'enregistrement d'informations, un appareil de mesure et un plan d'une mire pour la mise en œuvre de ce procédé de mesure du désalignement.

Une zone de gravure est une zone d'un substrat à l'intérieur de laquelle est gravé un élément ou une partie d'un élément. Ce substrat est connu sous le terme anglais de « wafer ». Les première et seconde zones de gravure sont telles qu'il peut exister un désalignement accidentel entre ces deux zones de gravure, c'est-à-dire un décalage non souhaité d'une zone de gravure par rapport à l'autre. Un décalage est « non souhaité » ou « accidentel » lorsque ce décalage n'existe pas dans le plan codant les dimensions, l'agencement et l'emplacement des éléments à graver sur le substrat alors qu'il existe une fois que ces éléments ont réellement été réalisés sur le substrat. Ce décalage est causé par des défauts ou des erreurs de réglages des machines utilisées pour réaliser ces éléments sur le substrat. Parmi les différentes machines utilisées pour réaliser ces éléments sur le substrat, c'est souvent la machine de lithographie qui est à l'origine des décalages les plus importants.

Une machine de lithographie est par exemple une machine de lithographie par faisceaux d'électrons. Une machine de lithographie par faisceaux d'électrons est souvent utilisée pour dessiner des motifs dans une couche de résine déposée sur la face du substrat. La couche de résine est sensible aux électrons du faisceau. Ensuite, par exemple, des régions de la résine qui n'ont pas été irradiées par le faisceau d'électrons sont éliminées et l'on obtient ainsi un masque qui occulte certaines régions de la face du substrat et laisse d'autres régions directement exposées à l'extérieur. Puis en appliquant à travers ce masque un agent de gravure, les régions non occultées par le masque sont éliminées tandis que les régions occultées par ce masque sont protégées et ne sont donc pas gravées. Un tel masque permet donc de graver les motifs dessinés dans la face du substrat.

Avec une machine mono-faisceau de lithographie par faisceau d'électrons, sans déplacer le substrat par rapport à la source de ce faisceau d'électrons, il est possible de dessiner un motif dans seulement une petite zone de gravure. Pour cela, le faisceau d'électrons est déplacé par déflexion tout en conservant la source de ce faisceau immobile par rapport au substrat. Cette petite zone est appelée « champ » ou « champ d'exposition » dans le cas d'une machine de lithographie par faisceau d'électrons. La surface de ce champ est souvent inférieure ou égale à 1 cm² ou 1 mm². Elle est donc bien plus petite que la surface de la face du substrat à graver. Par conséquent, pour dessiner sur toute la face du substrat, il faut déplacer, l'un par rapport à l'autre, le substrat et la source du faisceau d'électrons. Dans ce cas, le substrat et la source occupent, l'un par rapport à l'autre, au cours du temps différentes positions relatives. Chaque position relative du substrat par rapport à la source du faisceau d'électrons correspond à un champ respectif. Les différents champs utilisés pour dessiner sur la totalité de la face du substrat sont généralement alignés en lignes et en colonnes contiguës ou se chevauchant légèrement. Toutefois, suite à des imprécisions sur le positionnement du substrat par rapport au faisceau d'électrons, il peut arriver que deux champs contigus ne soient pas parfaitement alignés l'un par rapport à l'autre. Il existe alors un désalignement entre ces deux champs. Un tel désalignement est également connu sous le terme anglais de « stitching » ou « field stitching ». Un tel désalignement peut provoquer une rupture abrupte ou une déformation non souhaitée d'un motif à cheval sur ces deux champs.

Il est donc souhaitable de mesurer ce désalignement, c'est-à-dire d'en mesurer l'amplitude, pour le corriger et en limiter l'amplitude.

Pour cela, des procédés connus de mesure du désalignement comportent :
- la fourniture d'un plan contenant des instructions codant notamment les dimensions, l'agencement et l'emplacement d'une mire à réaliser, sur un substrat, à cheval entre les première et seconde zones,
- la réalisation de la mire sur le substrat en exécutant les instructions contenues dans le plan fourni et en utilisant une machine de lithographie, puis
- la détermination de l'amplitude du désalignement à partir de l'observation de la mire réalisée sur le substrat.

Par exemple, l'article suivant décrit la réalisation sur le substrat d'une mire en forme d'échelle de Verniers et la mesure du désalignement à l'aide d'un microscope électronique à balayage : Tine Greibe et Al : « Quality control of JEOL JBX-9500FSZ e-beam lithography system in a multi-user laboratory », Microelectronic Engineering 155 (2016) 25-28.

Un tel procédé de mesure du désalignement est lent et compliqué car il faut utiliser un microscope électronique à balayage.

Le même problème existe avec des machines multi-faisceaux de lithographie par faisceaux d'électrons. Ces machines multi-faisceaux, contrairement à une machine mono-faisceau, permettent d'irradier simultanément, chacune avec son propre faisceau d'électrons, plusieurs champs adjacents les uns aux autres. Ces champs adjacents sont alignés les uns à côté des autres. Toutefois, comme dans le cas d'une machine mono-faisceau, il peut exister un désalignement entre ces différents champs adjacents irradiés simultanément. Dans le cas des machines multi-faisceaux, au moins l'une des dimensions des champs est généralement beaucoup plus petite que les dimensions des champs d'une machine mono-faisceau. Par exemple, cette dimension plus petite peut être inférieure à 10 µm ou 2 µm.

Dans ce dernier cas, se pose un problème supplémentaire, à savoir que les mires connues sont trop grandes pour être réalisées à l'intérieur d'un seul champ d'une machine multi-faisceaux.

Lorsque différentes couches structurées sont superposées les unes au-dessus des autres, il peut aussi exister un désalignement entre ces différentes couches. Une couche structurée est une couche qui a été gravée pour y réaliser un ou plusieurs éléments. Dans ce cas, chaque couche structurée correspond à une zone de gravure respective et ce désalignement est parfois désigné par l'expression anglaise de « overlay accuracy ». Il est mesuré de façon similaire à ce qui vient d'être décrit dans le cas particulier du désalignement entre deux champs d'une machine de lithographie par faisceaux d'électrons. On remarquera que le désalignement entre deux couches peut exister quelle que soit la technologie utilisée par la machine de lithographie pour dessiner les motifs à graver. Par exemple, le problème du désalignement entre deux couches structurées se rencontre aussi lorsque qu'une machine de photolithographie a été utilisée pour dessiner les éléments à graver.

Ainsi, il existe de nombreuses situations où le désalignement entre deux zones de gravure doit être mesuré.

De l'état de la technique est également connu de :
- US 2011/229010 A1, qui divulgue une méthode de mesure de désalignement entre deux zones d'exposition basée sur des mires formées par des parties dans deux zones.
- US 2015/198524 A1 qui divulgue un procédé de mesure de désalignement utilisant la résonance plasmonique pour permettre la détection de mires sous la limite de résolution en introduisant des antennes plasmoniques dans un élément optique.
- US 2014/132948 A1 qui discute du problème de la taille des mires de métrologie, mais qui décrit la résonance plasmonique comme une perturbation à éviter.
- US 2014/211195 A1 qui divulgue une jauge de déformation basée sur des antennes plasmoniques où la variation de l'absorption est corrélée à une variation de distance entre les éléments de l'antenne.

L'invention vise à proposer un procédé de mesure du désalignement entre deux zones de gravure qui est simple et rapide. Elle a donc pour objet un tel procédé conforme à la revendication 1.

Dans le procédé revendiqué, s'il existe un désalignement entre la première et la seconde zones de gravure, alors cela modifie les dimensions du creux de l'antenne plasmonique et donc le taux d'absorption de cette antenne plasmonique. Ainsi, à partir du taux d'absorption mesuré de l'antenne plasmonique et d'une valeur prédite pour ce taux d'absorption en absence de désalignement, il est possible de déterminer l'amplitude du désalignement entre ces deux zones de gravure. Le taux d'absorption de l'antenne plasmonique peut facilement et rapidement être mesuré à l'aide d'une source de rayonnement polarisé et d'un capteur d'intensité du rayonnement réfléchi. Par conséquent, le procédé revendiqué permet de mesurer rapidement et simplement le désalignement entre deux zones de gravure sans avoir à utiliser pour cela du matériel complexe et lent tel qu'un microscope électronique à balayage.

De plus, les dimensions d'une antenne plasmonique peuvent être inférieures à 10 µm ou 5 µm. Ainsi, le procédé revendiqué peut être mis en œuvre pour mesurer un désalignement entre des zones de gravure beaucoup plus petites que ce qui est possible avec des mires conventionnelles.

Enfin, dans le cas où les zones sont des champs d'une machine de lithographie par faisceaux d'électrons, pour réaliser l'antenne plasmonique, il n'est pas nécessaire que ces champs se chevauchent. À l'inverse, pour réaliser les mires conventionnelles, il est souvent nécessaire de prévoir un tel chevauchement entre les deux champs adjacents.

Les modes de réalisation de ce procédé de mesure peuvent comporter une ou plusieurs des caractéristiques des revendications dépendantes de procédé.

L'invention a également pour objet un support d'enregistrement d'informations comportant des instructions pour la mise en œuvre du procédé revendiqué, lorsque ces instructions sont exécutées par un microprocesseur.

L'invention a également pour objet un appareil de mesure du désalignement entre une première et une seconde zones de gravure pour la mise en œuvre du procédé revendiqué.

L'invention a également pour objet un plan d'une mire pour la mise en œuvre du procédé revendiqué.

L'invention sera mieux comprise à la lecture de la description qui va suivre, donnée uniquement à titre d'exemple non limitatif et faite en se référant aux dessins sur lesquels :
- la figure 1 est une illustration schématique d'un appareil de mesure du désalignement entre deux zones de gravure ;
- la figure 2 est une illustration schématique et partielle, en coupe verticale, d'une portion d'un substrat utilisé pour mesurer un désalignement entre deux zones de gravure ;
- la figure 3 est une illustration schématique d'une machine de lithographie par faisceaux d'électrons ;
- la figure 4 est une illustration schématique, partielle, et en vue de dessus d'une mire utilisée pour mesurer un désalignement entre deux zones de gravure ;
- la figure 5 est une illustration plus détaillée d'une antenne plasmonique de la mire de la figure 4 ;
- la figure 6 est une illustration schématique d'une mire effectivement réalisée sur un substrat à partir d'un plan codant la mire de la figure 5 ;
- les figures 7 à 10 sont des illustrations schématiques en vue de dessus de différents désalignements susceptibles d'être rencontrés lors de la réalisation de la mire de la figure 4 sur un substrat ;
- la figure 11 est un organigramme d'un procédé de mesure du désalignement entre deux zones de gravure à l'aide de la mire de la figure 4 et de l'appareil de la figure 1 ;
- les figures 12 à 14 sont des illustrations partielles schématiques et en coupe verticale d'autres modes de réalisation possibles de la mire de la figure 4 ;
- les figures 15 à 20 sont des illustrations schématiques, en vue de dessus, de différents autres modes de réalisation possibles pour une antenne plasmonique de la mire de la figure 4.

Dans ces figures, les mêmes références sont utilisées pour désigner les mêmes éléments. Dans la suite de cette description, les caractéristiques et fonctions bien connues de l'homme du métier ne sont pas décrites en détail.

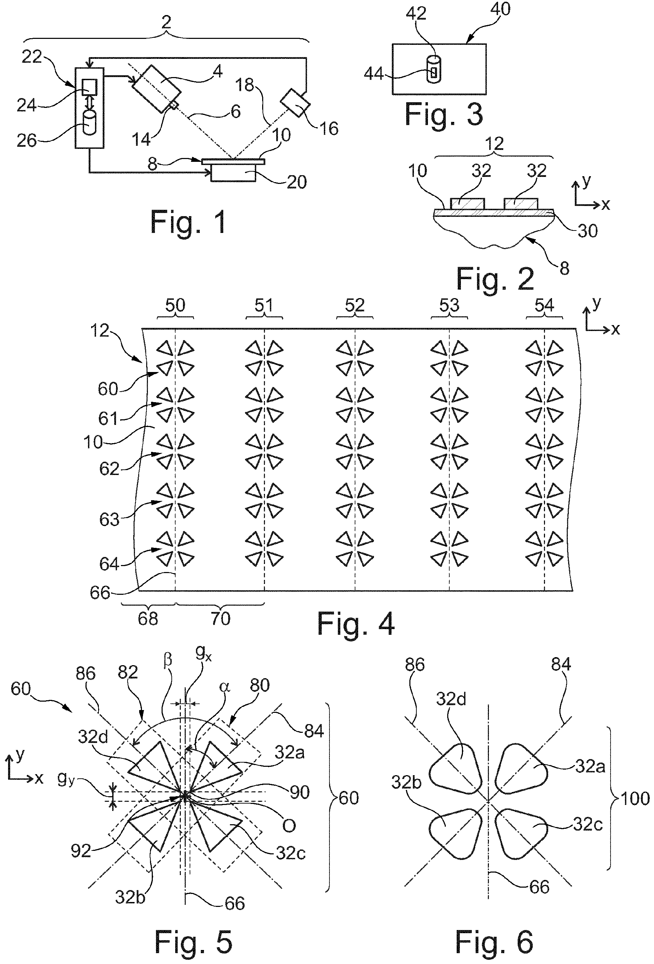

La figure 1 représente un appareil 2 pour mesurer un désalignement entre deux zones de gravure. Par la suite, la description est faite dans le cas particulier où ces zones de gravure correspondent à des champs adjacents d'une machine multi-faisceaux 40 (figure 3) de lithographie par faisceaux d'électrons.

L'appareil 2 comporte une source 4 de rayonnement apte à émettre un faisceau 6 polarisé à une longueur d'onde λₘ en direction d'un substrat 8 sur la face supérieure 10 duquel a été réalisée une mire 12 (figure 2). Par exemple, le faisceau 6 est un faisceau collimaté de manière à n'irradier qu'une portion choisie de la mire 12.

Le faisceau 6 est une onde électromagnétique. Ici, pour accroître la résolution de l'appareil 2, la longueur d'onde λₘ est inférieure à 2000 nm ou 700 nm et, généralement, supérieure à 390 nm. De préférence, la longueur d'onde λₘ est comprise entre 390 nm et 700 nm, c'est-à-dire comprise dans le spectre visible. Dans ce cas, l'intensité du faisceau 6 peut être exprimée en candela. Dans le cas où la longueur d'onde λₘ est en dehors du spectre visible, l'intensité correspond à la puissance rayonnée, c'est-à-dire au flux énergétique.

La source 4 comporte un polariseur tournant 14 qui permet de faire varier la direction de polarisation du faisceau 6 en réponse à une commande.

L'appareil 2 comprend aussi :
- un capteur 16 apte à mesurer l'intensité du rayonnement réfléchi 18 par une portion de la mire 12,
- un actionneur 20 apte à déplacer le substrat 8 par rapport au faisceau 6 incident de manière à sélectionner la portion de la mire 12 exposée au faisceau 6, et
- une unité 22 de traitement apte à déterminer l'amplitude du désalignement entre deux zones de gravure en fonction des mesures du capteur 16 et de l'intensité du faisceau 6.

Par exemple, le capteur 16 comporte à cet effet un ou plusieurs photo-détecteurs.

L'unité 22 est raccordée :
- au capteur 16 pour recevoir les mesures d'intensité, et
- à la source 4 et à l'actionneur 20 pour les commander.

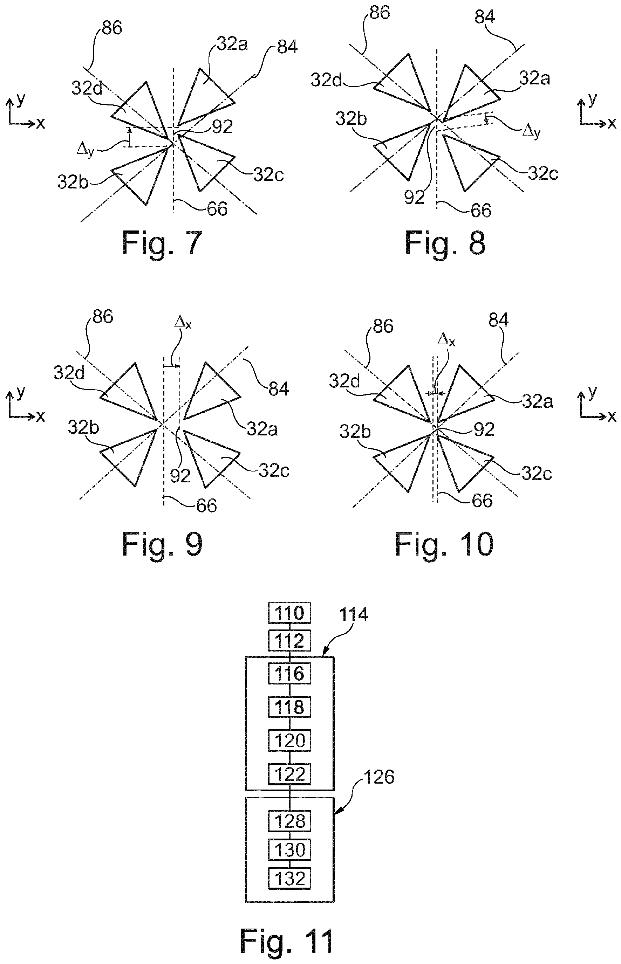

Par exemple, l'unité 22 comporte un microprocesseur 24 programmable et une mémoire 26. La mémoire 26 comporte notamment les instructions et les données nécessaires à l'exécution du procédé de la figure 11. Dans cet exemple, la mémoire 26 comporte aussi une ou plusieurs tables de conversion qui permettent de convertir des écarts Eₓ et E_{y} en amplitudes exprimées en mètres ou dans une sous-unité du mètre.

La figure 2 représente une portion du substrat 8 en coupe verticale. Dans cette description, les figures sont orientées par rapport à un repère orthogonal XYZ dans lequel Z est la direction verticale et X et Y sont deux directions orthogonales horizontales. La face supérieure 10 du substrat 8 est formée par une couche 30 en matériau diélectrique sur laquelle sont directement déposés des éléments 32 en matériau électriquement conducteur. L'association de cette couche 30 aux éléments 32 forme la mire 12. Ici, par matériau conducteur, on désigne un matériau dont la conductivité électrique à 20°C est supérieure à 10⁵ S/m et, de préférence, supérieure à 10⁶ S/m. Typiquement, il s'agit d'un métal tel que de l'or ou de l'argent. Par matériau diélectrique, on désigne ici un matériau dont la conductivité électrique à 20°C est inférieure à 10⁻² S/m ou à 10⁻⁴ S/m. Ici, les éléments 32 sont réalisés en or et la couche 30 est une couche de silice.

La figure 3 représente une machine multi-faisceaux 40 de lithographie par faisceau d'électrons utilisée pour dessiner dans une couche de résine sensible au faisceau d'électrons les motifs de la mire 12 qui définissent les dimensions, l'agencement et l'emplacement des différents éléments 32 de cette mire. Par exemple, cette couche de résine est déposée sur une couche métallique elle-même directement déposée sur la couche 30 en matériau diélectrique. Cette machine 40 comporte plusieurs champs contigus les uns aux autres et qui s'étendent parallèlement à la direction Y. La machine 40 comporte aussi une mémoire 42 contenant un plan 44. Le plan 44 comporte des instructions qui définissent les dimensions, l'agencement et l'emplacement sur le substrat 8 des différents éléments 32 de la mire 12. Ainsi, lorsque ces instructions sont exécutées par la machine 40, celle-ci dessine, dans la couche de résine, des motifs qui permettent d'obtenir un masque. Ce masque est ensuite utilisé pour graver la couche métallique et ainsi réaliser les éléments 32 de la mire 12.

La figure 4 représente plus en détail l'agencement et l'emplacement de la mire 12 telle que codée dans le plan 44. Sur cette figure, les lignes ondulées à droite et à gauche indiquent que seule une partie de la mire 12 est représentée. La mire 12 comporte plusieurs rangées 50 à 54 parallèles à la direction Y. Ces rangées 50 à 54 sont identiques les unes aux autres et seule la rangée 50 est décrite plus en détail.

La rangée 50 comporte plusieurs antennes plasmoniques 60 à 64 disposées chacune de part et d'autre d'un même plan vertical de séparation. Ce plan vertical de séparation coupe le plan horizontal du substrat au niveau d'une ligne 66 de séparation parallèle à la direction Y. Le plan du substrat est le plan dans lequel s'étend principalement le substrat 8. La ligne 66 est située sur la frontière entre deux champs adjacents 68 et 70 de la machine 40. Ainsi, une partie des éléments de chaque antenne 60 à 64 est située à l'intérieur du champ 68 et l'autre partie de ces éléments est située à l'intérieur du champ 70. Les antennes 60 à 64 sont ici identiques les unes aux autres et seule l'antenne 60 est décrite plus en détail.

La figure 5 représente l'antenne 60 telle que codée par les instructions contenues dans le plan 44. L'antenne 60 comporte deux paires 80 et 82 d'éléments 32. Ici, les paires 80 et 82 sont situées dans un même plan horizontal. La paire 82 se déduit de la paire 80 par une rotation d'angle β autour d'un axe vertical passant par un point O situé sur la ligne 66. Ici, l'angle β est égal à 90°. Par conséquent, seule la paire 80 est maintenant décrite plus en détail.

Pour distinguer les deux éléments 32 de la paire 80, sur cette figure et les suivantes, ils portent, respectivement, les références numériques 32a et 32b. De même, sur cette figure et les suivantes, les deux éléments 32 de la paire 82 portent, respectivement, les références numériques 32c et 32d.

Les éléments 32a et 32b sont situés, respectivement, à droite et à gauche de la ligne 66. Ils sont alignés sur un axe oblique 84 qui coupe la ligne 66 au niveau du point O avec un angle a. Dans ce mode de réalisation, l'axe 84 est aussi un axe de symétrie pour les éléments 32a et 32b. L'angle α est strictement supérieur à 0° et suffisamment grand pour que l'élément 32a soit entièrement situé du côté droit de la ligne 66 et ne touche pas cette ligne 66. L'angle α est également strictement inférieur à 90° de manière à ce que l'élément 32a ne touche pas l'élément 32c. Typiquement, l'angle α est compris entre 25° et 65° ou entre 35° et 55°. Ici, l'angle α est égal à 45° à ±5° ou ±2° près.

Les éléments 32c et 32d sont quant à eux alignés sur un axe 86. L'angle entre les axes 84 et 86 est égal à l'angle β. Dans ce mode de réalisation, l'élément 32b est en plus le symétrique de l'élément 32a par rapport à un axe horizontal perpendiculaire à l'axe 84 et passant par le point O. Ici, cet axe de symétrie est confondu avec l'axe 86. Par conséquent, par la suite, seul l'élément 32a est décrit plus en détail.

L'élément 32a comporte une pointe 90 dirigée vers le point O et séparée de ce point O par une distance g/2. Il existe donc une distance g qui sépare la pointe 90 de la pointe en vis-à-vis de l'élément 32b. À cause de cette distance g, il existe un creux 92 entre ces deux pointes. La même distance g existe entre les pointes en vis-à-vis des éléments 32c et 32d. Cette distance g fixe donc les dimensions du creux 92 entre les éléments 32a, 32b et entre les éléments 32c, 32d. Sur la figure 5, seule la dimension horizontale g_{X} et la dimension verticale g_{Y} du creux 92 ont été représentées. Ces dimensions g_{X}, g_{Y} se déduisent de la distance g à l'aide des relations suivantes : g_{X} = g.cos(α) et g_{Y} = g.sin(α), où le symbole « . » désigne l'opération de multiplication. Dans cet exemple, la section horizontale de l'élément 32a est un triangle plein et la pointe 90 est l'un des sommets de ce triangle. Dans ces conditions, les paires 80 et 82 forment chacune, respectivement, une première et une seconde antennes plasmoniques connues sous le terme anglais d'antenne « bowtie ». Par exemple, le triangle est un triangle équilatéral.

On rappelle ici qu'une antenne « bowtie » produit une résonance des plasmons de surface localisée à l'intérieur du creux 92 lorsqu'elle est exposée à un rayonnement incident polarisé dans une direction parallèle au plan du substrat 8. De plus, typiquement, la pulsation ω du rayonnement incident doit être inférieure à la pulsation ωₚ du matériau électriquement conducteur de l'antenne définie par la relation suivante : ωₚ = (N.e²/(ε₀.m*))^{0,5}, où :
- N est la concentration en porteurs de charge libres dans le matériau électriquement conducteur,
- e est la charge d'un électron,
- ε₀ est la permittivité du vide, et
- m* est la masse effective des électrons libres dans le matériau électriquement conducteur.
Pour qu'une résonance des plasmons de surface apparaisse, il faut aussi généralement que la partie réelle de la permittivité relative du matériau électriquement conducteur soit négative.

Par la suite, on note *λ*ₘₐₓ la longueur d'onde du rayonnement incident à laquelle l'amplitude de la résonance des plasmons de surface est maximale. La valeur de cette longueur d'onde λₘₐₓ dépend des dimensions de l'élément 32a.

L'homme du métier sait comment construire et dimensionner une antenne « bowtie » pour qu'une résonance des plasmons de surface se produise à une longueur d'onde λₘ souhaitée. Ici, l'antenne 60 est dimensionnée pour que les longueurs d'onde λₘₐₓ et λₘ soient égales à ± 10 % près ou ± 5 % près. Par exemple, le dimensionnement de élément 32a peut être déterminé par simulation numérique FDTD (« Finite Différente Time Domain »). En effet, le principe et les lois de fonctionnement de la paire 80 sont connus et ont déjà été simulés. À ce sujet, le lecteur peut se référer par exemple aux études suivantes :
- Sylvain Vedraine, Renjie Hou, Peter R. Norton, and François Lagugné-Labarthet, « On the absorption and electromagnetic field spectral shifts in plasmonic nanotriangle arrays", Opt. Exp. 22, 13308 (2014).
- K. Schraml, M. Spiegl, M. Kammerlocher, G. Bracher, J. Bartl, T. Campbell, J. J. Finley, and M. Kaniber, "Optical properties and interparticle coupling of plasmonic bowtie nanoantennas on a semiconducting substrate", PRB 90, 035435 (2014).

Ici, l'angle d'incidence du faisceau 6 à la longueur d'onde λₘ est strictement inférieur à 90°. De plus, il est choisi de manière à ce que la majorité du faisceau 6 soit réfléchi par l'antenne 60. À cause du phénomène de résonance des plasmons de surface, une partie de l'intensité du faisceau 6 est absorbée par l'antenne 60. Le taux d'absorption d'une antenne plasmonique peut être mesuré à partir du taux de réflexion et/ou du taux de transmission du rayonnement 6. Le taux de réflexion est égal au rapport Iᵣ/Iᵢ et le taux de transmission est égal au rapport Iₜ/Iᵢ, où :
- Iᵣ est l'intensité du rayonnement réfléchi par l'antenne plasmonique,
- Iₜ est l'intensité du rayonnement transmis à travers l'antenne plasmonique, et
- Iᵢ est l'intensité du faisceau incident 6.

Par la suite, dans ce mode de réalisation, le taux d'absorption de l'antenne plasmonique est mesuré par le taux de réflexion de l'antenne 60.

Le taux d'absorption varie en fonction des dimensions g_{X} et g_{Y} du creux 92. A l'inverse, la valeur de la longueur d'onde λₘₐₓ est pratiquement indépendante de ces dimensions g_{X} et g_{Y}.

La figure 6 représente schématiquement une antenne plasmonique 100 réalisée sur le substrat 8 en mettant en œuvre les instructions codant l'antenne 60 et contenues dans le plan 44. L'antenne 100 est représentée dans le cas particulier où il n'y a pas de désalignement entre les champs 68 et 70. Sur la figure 6, les éléments de l'antenne 100 correspondant aux éléments de l'antenne 60 portent les mêmes références numériques. Comme illustré sur cette figure, en pratique, avec les techniques de lithographie actuelles, il n'est pas possible de réaliser des pointes parfaites, comme celles représentées sur la figure 5. Au contraire, lorsque l'antenne 60 est réalisée sur le substrat 8, les pointes, comme la pointe 90, sont remplacées par des arrondis comme illustré sur la figure 6.

Ces déformations introduites par les différentes étapes de réalisation de l'antenne 60 peuvent entraîner une modification de la valeur de la longueur d'onde λₘₐₓ. Toutefois, des simulations numériques réalisées, ont montré que la longueur d'onde λₘ restait suffisamment proche de la longueur d'onde λₘₐₓ pour que l'antenne 100 réalisée produise quand même une résonance des plasmons de surface à l'intérieur du creux 92 lorsqu'elle est exposée au rayonnement de longueur d'onde λₘ. Ainsi, malgré des écarts entre la forme théorique de l'antenne 60 codée dans le plan 44 et la forme réellement obtenue, le procédé de mesure du désalignement décrit par la suite fonctionne. Par conséquent, dans la suite de cette description, comme dans les figures suivantes, les écarts entre les dimensions des antennes 60 et 100 sont ignorés pour simplifier les explications. En particulier, sur les figures suivantes, les éléments 32a à 32d de l'antenne 100 sont représentés comme étant identiques aux éléments 32a à 32d de l'antenne 60.

Les figures 7 à 10 représentent l'antenne 100 lorsque le désalignement entre les champs 68 et 70 est non nul. Plus précisément, on note Δx et Δy l'amplitude du désalignement entre les champs 68 et 70 parallèlement, respectivement, aux directions X et Y. Par convention, les amplitudes Δx et Δy ont une valeur positive si le désalignement correspond à un déplacement des éléments 32a, 32c par rapport aux éléments 32b et 32d dans le sens des directions, respectivement, X et Y. À l'inverse, les amplitudes Δx et Δy ont une valeur négative en présence d'un déplacement de sens opposé au sens des directions X et Y.

Les figures 7 et 8 représentent les conséquences d'un désalignement lorsque l'amplitude Δx est nulle et l'amplitude Δy est positive (figure 7) ou négative (figure 8). Les figures 9 et 10 représentent les conséquences d'un désalignement lorsque l'amplitude Δy est nulle et l'amplitude Δx est positive (figure 9) ou négative (figure 10).

Comme illustré sur ces figures 7 à 10, un désalignement non nul entre les champs 68 et 70 se traduit par une modification des dimensions du creux 92, et donc par une modification du taux d'absorption à la longueur d'onde λₘ. Par contre, un désalignement non nul ne modifie pas ou pratiquement pas la valeur de la longueur d'onde λₘₐₓ car les dimensions des éléments 32a à 32d ne sont pas modifiées. Par conséquent, le taux d'absorption de l'antenne 100 varie essentiellement en fonction du désalignement entre les champs 68 et 70. Dès lors, l'amplitude du désalignement peut être déterminée à partir :
- d'une valeur prédite du taux d'absorption de l'antenne 100 en absence de désalignement, c'est-à-dire pour un désalignement d'amplitude nul, et
- du taux d'absorption réellement mesuré pour l'antenne 100.

Dans ce mode de réalisation particulier, on cherche à mesurer l'amplitude Δy et, en même temps, l'amplitude Δx. De plus, dans ce mode de réalisation, on souhaite en plus connaître le sens du déplacement des éléments 32a, 32c par rapport aux éléments 32b et 32d. Pour cela, il a été observé que lorsque l'amplitude Δy du désalignement est positive, la taille du creux 92 entre les éléments 32a et 32b augmente tandis que la taille du creux 92 entre les éléments 32c et 32d diminue. Dans ces conditions, lorsque l'amplitude Δy augmente, le taux d'absorption de la paire 80 diminue tandis que, dans le même temps, le taux d'absorption de la paire 82 augmente. Le comportement inverse est observé lorsque l'amplitude Δy est négative. Pour exploiter cette propriété, un rapport A_{Y} est défini par la relation suivante A_{Y} = T₊₄₅/T-₄₅, où :
- T₊₄₅ est le taux d'absorption de l'antenne 100 mesuré à l'aide d'un rayonnement incident à la longueur d'onde λₘ et dont la direction de polarisation est parallèle à l'axe 86, et
- T₋₄₅ est le taux d'absorption de l'antenne 100 mesuré à l'aide d'un rayonnement incident à la longueur d'onde λₘ et dont la direction de polarisation est parallèle à l'axe 84.

De plus, ce rapport A_{Y} présente l'avantage d'être très peu dépendant de l'amplitude du désalignement Δx. En effet, une amplitude Δx non nulle modifie sensiblement de la même façon les taux d'absorption T₋₄₅ et T₊₄₅ de sorte que le rapport A_{Y} varie peu en réponse à une modification de l'amplitude Δx. Enfin, lorsque l'amplitude Δy est nulle, les dimensions du creux 92 entre les éléments 32a, 32b et entre les éléments 32c, 32d sont identiques de sorte que les taux d'absorption T₋₄₅ et T₊₄₅ sont égaux. Ainsi, la valeur prédite A_{YP} du rapport A_{Y} est facile à prédire puisqu'elle est égale à 1.

Dès lors, l'écart E_{Y} = 1-A_{Y} varie principalement en fonction de l'amplitude Δy et beaucoup moins en fonction de l'amplitude Δx. Cet écart E_{Y} est donc principalement représentatif de l'amplitude du désalignement entre les champs 68 et 70 dans la seule direction Y.

Si nécessaire, cet écart E_{Y} peut être converti en une valeur de l'amplitude Δy exprimée en nanomètre à l'aide d'une table de conversion. Par exemple, cette table de conversion est construite en calculant, par simulation numérique ou par des mesures expérimentales, la valeur de l'écart E_{Y} pour différentes valeurs connues de l'amplitude Δy. Ici, pour simplifier, en première approximation, il est considéré que l'écart E_{Y} est égal, à une constante multiplicative près, à l'amplitude Δy. Autrement dit, la table de conversion se résume ici à la relation suivante Δy = A.E_{Y} où A est une constante multiplicative connue, déterminée lors d'une calibration initiale du procédé.

Les taux T₊₄₅ et T₋₄₅ de l'antenne 100 peuvent être mesurés en exposant cette antenne 100 à des rayonnements polarisés dans les directions parallèles, respectivement, aux axes 86 et 84. En effet, un rayonnement polarisé parallèle à l'axe 84 excite presque uniquement la paire d'éléments 32a, 32b, et n'excite quasiment pas la paire d'éléments 32c, 32d qui sont alignés sur un axe orthogonal à l'axe 84. Dès lors, la résonance des plasmons de surface à l'intérieur du creux 92 est principalement due aux éléments 32a et 32b. Dès lors, le taux d'absorption mesuré avec un tel rayonnement polarisé correspond au taux d'absorption T₋₄₅. De même, en exposant l'antenne 100 à un rayonnement polarisé parallèlement à la direction 86, il est possible de mesurer le taux T₊₄₅.

Lorsque l'amplitude Δx est supérieure à 0 (figure 9) alors les éléments 32 les plus proches les uns des autres sont les éléments 32a et 32c et les éléments 32b, 32d. Dans ce cas, en exposant successivement l'antenne 100 à des rayonnements dont les directions de polarisation sont parallèles aux directions, respectivement, Y et X, il peut être observé que le taux d'absorption est plus important avec le rayonnement polarisé dans la direction Y qu'avec le rayonnement polarisé dans la direction X. En effet, la distance qui sépare l'élément 32a des éléments 32d et 32b est plus grande que celle qui sépare cet élément 32a de l'élément 32c. À l'inverse, lorsque l'amplitude Δx est inférieure à 0 (figure 10), c'est le taux d'absorption mesuré avec le rayonnement polarisé dans la direction Y qui est plus faible que le taux d'absorption mesuré avec le rayonnement polarisé dans la direction X. En effet, dans ce dernier cas, l'élément 32a est plus proche de l'élément 32d que des éléments 32b et 32c.

Pour exploiter cette propriété, un rapport A_{X} est défini comme suit : A_{X} = T₉₀/T₀, où :
- T₉₀ est le taux d'absorption de l'antenne 100 mesuré à l'aide d'un rayonnement incident à la longueur d'onde λₘ et dont la direction de polarisation est parallèle à la direction X, et
- T₀ est le taux d'absorption de l'antenne 100 mesuré à l'aide d'un rayonnement incident à la longueur d'onde λₘ et dont la direction de polarisation est parallèle à la direction Y.

Ce rapport A_{X} varie en fonction de l'amplitude Δx du désalignement dans la direction X. De plus, il a été observé, par simulation numérique, que le rapport A_{X} est pratiquement indépendant de l'amplitude Δy.

En absence de désalignement, c'est-à-dire pour des amplitudes Δx et Δy nulles, l'élément 32a est à la même distance des éléments 32c et 32d. Ainsi, en absence de désalignement, les taux d'absorption T₉₀ et T₀ sont égaux et la valeur prédite A_{XP} du rapport A_{X} est donc égale à 1. Par conséquent, l'écart E_{X} = 1 - A_{X} varie essentiellement en fonction de l'amplitude Δx et pratiquement pas en fonction de l'amplitude Δy Cet écart E_{X} est donc représentatif de l'amplitude du désalignement dans la seule direction X.

Comme pour les taux de transmission T₋₄₅ et T₊₄₅, les taux d'absorption T₉₀ et T₀ peuvent être mesurés en exposant l'antenne 100 à des rayonnements dont les directions de polarisation sont parallèles aux directions, respectivement, Y et X.

La figure 11 représente un procédé de mesure du désalignement entre les champs 68 et 70 à l'aide de l'appareil 2 et de la mire 12.

Lors d'une étape 110, initialement, le plan 44 de la mire 12 est conçu puis fourni à la machine 40. Typiquement, il est enregistré dans la mémoire 42.

Ensuite, lors d'une étape 112, on procède à la réalisation de la mire 12 sur le substrat 8 en utilisant pour cela la machine 40. Typiquement, lors de cette étape, la machine 40 expose une couche de résine, directement déposée sur une couche métallique, aux faisceaux d'électrons de cette machine 40. Lors de cette étape, les faisceaux d'électrons dessinent la mire 12 dans cette couche de résine sensible aux faisceaux d'électrons. Ensuite, les portions de cette couche de résine non exposée sont éliminées pour former un masque de gravure. La couche métallique est alors gravée à travers ce masque pour former, dans cette couche métallique, les éléments 32 de la mire 12. On obtient ainsi la mire 12 et notamment l'antenne 100.

Lors de cette étape 112, les éléments 32a, 32c sont réalisés à l'intérieur du champ 70, tandis que les éléments 32b, 32d sont réalisés à l'intérieur du champ 68. Ainsi, s'il existe un désalignement entre ces champs 68 et 70, cela se traduit nécessairement par un décalage des éléments 32a, 32c, par rapport aux éléments 32b et 32d, et donc par une modification des dimensions g_{X} et g_{Y} du creux 92.

Une fois la mire 12 réalisée sur le substrat 8, lors d'une étape 114, les taux d'absorption T₊₄₅, T₋₄₅, T₉₀ et T₀ sont mesurés à l'aide de l'appareil 2. Lors de cette étape, le faisceau 6 est, par exemple, dirigé sur une seule antenne plasmonique ou sur un groupe restreint d'antennes plasmoniques de la mire 12. Par exemple, le groupe restreint contient uniquement plusieurs antennes plasmoniques à cheval sur une même frontière entre deux champs contigus. Un tel groupe restreint peut contenir de deux à dix antennes plasmoniques. Ici, la suite de cette description est faite dans le cas particulier où le faisceau 6 est dirigé sur la seule antenne 100. Toutefois, tout ce qui est décrit dans ce cas particulier s'applique aussi au cas des autres antennes plasmoniques de la mire 12 et au cas d'un groupe restreint d'antennes plasmoniques.

Pour diriger le faisceau 6 sur l'antenne 100, l'actionneur 20 est commandé par l'unité 22 pour déplacer le substrat 8 par rapport au faisceau 6.

Une fois que le faisceau 6 est dirigé sur l'antenne 100, l'unité 22 procède à une opération 116 de mesure du taux d'absorption T₋₄₅. Pour cela, l'unité 22 commande le polariseur 14 pour sélectionner une direction de polarisation parallèle à l'axe 84. Ensuite, l'unité 22 commande la source 4 pour exposer l'antenne 100 au faisceau 6 ainsi polarisé. L'intensité Iᵢ du faisceau 6 est connue. En parallèle, le capteur 16 mesure l'intensité Iᵣ du rayonnement réfléchi par l'antenne 100 et transmet cette mesure à l'unité 22 qui l'acquiert. En réponse, l'unité 22 calcule le taux d'absorption T₋₄₅.

L'étape 14 comporte également des opérations 118, 120 et 122 identiques à l'opération 116 sauf que lors de ces opérations, l'unité 22 commande le polariseur 14 pour avoir des directions de polarisation parallèles, respectivement, à l'axe 86, à la direction Y puis à la direction X. Ainsi, à l'issue des opérations 116, 118, 120 et 122, l'unité 22 a mesuré les taux d'absorption T₋₄₅, T₄₅, T₉₀ et T₀.

L'étape 114 est répétée pour chaque antenne plasmonique de la mire 12 ou pour chaque groupe restreint d'antennes plasmoniques de la mire 12. De plus, dans cet exemple particulier, l'étape 114 est réitérée pour différentes longueurs d'onde λₘᵢ, où l'indice i est un identifiant de la longueur d'onde utilisée pour réaliser les mesures des taux d'absorption T₄₅, T₋₄₅, T₉₀ et T₀. Typiquement, cette étape 114 est répétée pour au moins deux et, de préférence, au moins cinq ou dix longueurs d'onde λₘᵢ différentes. Par exemple, ces longueurs d'onde λₘᵢ sont uniformément réparties sur un intervalle centré autour de la valeur prédite pour la longueur d'onde λₘₐₓ.

Une fois que les taux d'absorption souhaités ont été mesurés, lors d'une étape 126, l'unité 22 détermine différentes erreurs de réalisation introduite par la machine 40.

Plus précisément, lors d'une opération 128, l'unité 22 détermine l'amplitude Δy du désalignement dans la direction Y. Pour cela, l'unité 22 calcule l'écart E_{Y} puis convertit, à l'aide de la table de conversion, cet écart en une amplitude Δy exprimée en nanomètre. De plus, le signe de cet écart E_{Y} donne le sens du déplacement, parallèlement à la direction Y, des éléments 32a, 32c par rapport aux éléments 32b, 32d.

Lors d'une opération 130, l'unité 22 détermine l'amplitude Δx du désalignement dans la direction X. L'opération 130 est identique à l'opération 128 sauf que l'on utilise l'écart E_{X} à la place de l'écart E_{Y}. Ainsi, à l'issue de ces opérations 128 et 130, l'unité 22 a déterminé l'amplitude et le sens du désalignement parallèlement aux directions X et Y des champs 68 et 70.

En plus du désalignement entre les champs 68, 70, il peut aussi exister des erreurs qui modifient les dimensions des éléments 32. Typiquement, une erreur de dimensionnement est causée par une erreur de focalisation du faisceau d'électrons dans la couche de résine. Par exemple, si le point de focalisation du faisceau d'électrons se situe en-dessous de la couche de résine, alors les dimensions des éléments 32a à 32d sont grossies. Une telle erreur de dimensionnement peut s'exprimer sous la forme d'un facteur d'échelle exprimé en pourcentage par rapport aux dimensions codées dans le plan 44.

Ici, pour quantifier l'erreur de dimensionnement, lors d'une opération 132, l'unité 22 estime la valeur de la longueur d'onde λₘₐₓ. Pour cela, l'unité 22 utilise les taux d'absorption calculés aux différentes longueurs d'onde λₘᵢ. En effet, lorsque l'amplitude de la résonance des plasmons de surface est maximale, cela correspond également à un maximum du taux d'absorption. Pour estimer cette valeur de la longueur d'onde λₘₐₓ, l'unité 22 peut utiliser uniquement les taux d'absorption mesurés avec une seule ou, au contraire, avec plusieurs directions de polarisation. Ensuite, toujours lors de cette opération 132, l'unité 22 calcule un écart E_{D} entre la valeur estimée de la longueur d'onde λₘₐₓ et une valeur prédite pour cette longueur d'onde λₘₐₓ en absence de désalignement. En effet, une modification des dimensions du creux 92 ne modifie quasiment pas la valeur de la longueur d'onde λₘₐₓ. La valeur prédite de la longueur d'onde λₘₐₓ est par exemple prédite par simulation numérique ou mesurée expérimentalement en absence de désalignement. Ensuite, l'écart E_{D} ainsi calculé est converti en un pourcentage ou en une amplitude exprimée en nanomètre à l'aide d'une table de conversion.

Les étapes 128, 130 et 132 peuvent être réitérées pour d'autres antennes plasmoniques situées sur la même ligne 66 de séparation. Dans ce cas, typiquement, les amplitudes Δx et Δy sont égales à une moyenne des amplitudes Δx et Δy obtenues à partir de chaque antenne plasmonique située sur la ligne 66.

Il a été observé que les rapports A_{X} et A_{Y} varient de pratiquement 10 % pour une amplitude Δx ou Δy de quelques nanomètres. Ainsi, en appliquant le procédé décrit ici, il est possible de mesurer un désalignement avec une résolution inférieure à 1 nm ou 2 nm.

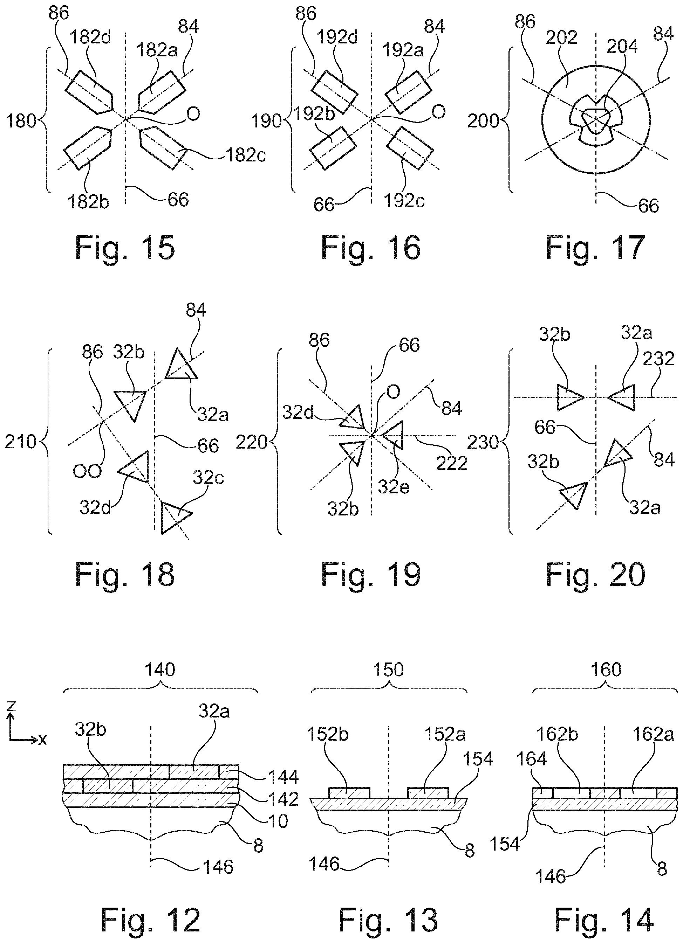

La figure 12 représente un autre mode de réalisation de la mire 12 dans laquelle l'antenne 100 est remplacée par une antenne plasmonique 140. L'antenne 140 est identique à l'antenne 100 sauf que les éléments 32b et 32d sont disposés à l'intérieur d'une couche 142 en matériau diélectrique directement déposée sur la couche 10. Les éléments 32a et 32c sont déposés à l'intérieur d'une couche 144 en matériau diélectrique directement déposée sur la couche 142. Sur la figure 12, seuls les éléments 32a et 32b ont été représentés. Dans ce mode de réalisation, les couches 142 et 144 correspondent à deux zones de gravure distinctes puisqu'elles sont gravées l'une après l'autre en mettant en œuvre, par exemple, une même machine de lithographie. Plus précisément, la machine de lithographie est utilisée une première fois pour construire le masque de gravure de la couche 142 puis une seconde fois pour construire le masque de gravure de la couche 144. Dans ce mode de réalisation, la machine de lithographie peut être la machine 40 ou une autre machine de lithographie, comme une machine de photolithographie. De façon similaire à ce qui a été décrit dans le cas du désalignement entre les champs 68, 70, il peut exister un désalignement dans la direction X et/ou dans la direction Y entre les couches 142 et 144. Ce désalignement peut être mesuré dans les directions X et Y en utilisant l'antenne plasmonique 140 à la place de l'antenne 100 et, par exemple, en mettant en œuvre le même procédé que celui décrit en référence à la figure 11.

Sur la figure 12 et sur les figures 13 et 14, un plan vertical 146 de séparation a été représenté. Ce plan 146 correspond au plan de séparation précédemment décrit. En particulier, tout ce qui a été décrit dans le cas de la ligne 66 s'applique aux projections orthogonales des éléments 32 dans le plan du substrat. En effet, la projection orthogonale du plan 146 dans le plan du substrat forme la ligne de séparations entre les projections orthogonales des éléments 32.

La figure 13 représente une antenne plasmonique 150 apte à remplacer l'antenne 100 pour mesurer le désalignement dans les directions X et Y entre les champs 68 et 70. L'antenne 150 est identique à l'antenne 100 sauf que :
- les éléments 32a à 32d sont remplacés, respectivement, par des éléments 152a à 152d, et
- la couche 30 est remplacée par une couche 154 en matériau électriquement conducteur.

Sur la figure 13, seuls les éléments 152a et 152b ont été représentés. Dans ce mode de réalisation, les éléments 152a à 152d sont identiques, respectivement aux éléments 32a à 32d sauf qu'ils sont réalisés en matériau diélectrique. Typiquement, les éléments 152a à 152d sont réalisés dans une résine sensible au faisceau d'électrons. Ainsi, ce mode de réalisation évite une étape de gravure d'une couche en matériau électriquement conducteur pour réaliser une antenne plasmonique. Toutefois, de par sa construction, la variation du taux d'absorption de l'antenne 150 en fonction des dimensions g_{X} et g_{Y} est moins rapide que dans le cas de l'antenne 100 de sorte que la résolution du procédé de mesure est plus faible avec l'antenne 150.

La figure 14 représente une antenne plasmonique 160 apte à remplacer l'antenne 150. L'antenne 160 est identique à l'antenne 150 sauf que les éléments 152a à 152d sont remplacés, respectivement, par des éléments 162a à 162d. Sur la figure 14, seuls les éléments 162a et 162b sont représentés. La forme des éléments 162a à 162d est identique à celle des éléments 152a à 152d sauf que ces éléments 162a à 162d sont des cavités réalisées dans une couche 164 en matériau diélectrique directement déposé sur la couche 154. Ce mode de réalisation présente les mêmes avantages et inconvénients que celui de la figure 13.

De nombreux autres modes de réalisation d'une antenne plasmonique comportant au moins deux éléments distincts et susceptible d'être utilisée pour la mise en œuvre du procédé de la figure 11 sont possibles. Par exemple, les éléments 32a à 32d peuvent être remplacés par des éléments de forme différente tels que ceux représentés sur les figures 15 à 17.

La figure 15 représente une antenne plasmonique 180 identique à l'antenne 60 sauf que les éléments 32a à 32d sont remplacés, respectivement, par des éléments 182a à 182d. Dans ce mode de réalisation, chaque élément 182a à 182d est formé par la juxtaposition d'un triangle et d'un rectangle ou d'un carré. Un côté du rectangle forme un côté du triangle. Un tel mode de réalisation d'une antenne plasmonique 180 est par exemple décrit plus en détail dans l'article suivant : P. Biagoni et Al : « Cross Resonant Optical Antenna », Physical Review Letter, n°102, 256801, 26/6/2009.

La figure 16 représente une antenne plasmonique 190 identique à l'antenne 60 sauf que les éléments 32a à 32d sont remplacés, respectivement, par des éléments 192a à 192d. Les éléments 192a à 192d sont identiques aux éléments 32a à 32d sauf qu'il s'agit de rectangle ou de carré et non plus de triangle.

La figure 17 représente une antenne plasmonique 200 comportant deux éléments concentriques 202 et 204. Une telle antenne plasmonique est décrite plus en détail dans l'article suivant : Alexei Smolyaninov et Al : « Broadband metacoaxial nanoantenna for metasurface and sensing applications », Optics Express 22786, Vol. 22, N°19, 22/09/2014. Ce mode de réalisation est particulièrement adapté au cas où les zones de gravure entre lesquelles il faut mesurer un désalignement sont des couches différentes comme les couches 142 et 144 de la figure 12. Dans ce cas, par exemple, l'élément 202 est réalisé à l'intérieur de la couche 142 et élément 204 est réalisé à l'intérieur de la couche 144. Dans ce mode de réalisation particulier, le plan de séparation entre les éléments 202 et 204 est horizontal et parallèle au plan du substrat.

D'autres modes de réalisation d'une antenne plasmonique peuvent aussi être obtenus en agençant différemment les éléments 32a à 32d les uns par rapport aux autres. À titre d'illustration, les figures 18 à 20 représentent trois antennes plasmoniques différentes susceptibles chacune d'être utilisées à la place de l'antenne 60.

La figure 18 représente une antenne plasmonique 210 identique à l'antenne 60 sauf que les axes 84 et 86 se coupent en un point OO éloigné de la ligne 66.

La figure 19 représente une antenne plasmonique 220 identique à l'antenne 60 sauf que les éléments 32a et 32c sont remplacés par un seul élément 32e de forme identique à élément 32a. L'élément 32e est aligné sur un axe 222 perpendiculaire à la ligne 66 et passant par le point O.

La figure 20 représente une antenne plasmonique 230 identique à l'antenne 210 sauf que l'axe 84 est remplacé par un axe 232 perpendiculaire à la ligne 66.

Le procédé de mesure d'un désalignement avec des antennes plasmoniques telles que celles représentées sur les figures 15 à 20 se déduit des explications données dans le cas du procédé de la figure 11.

### Variantes de la mire 12 :

Le nombre d'antennes plasmoniques contenues dans la mire 12 peut être différent. Dans un cas simplifié, la mire 12 comporte une seule antenne plasmonique ou une seule antenne plasmonique par frontière de séparation entre deux zones de gravure.

La mire 12 peut comporter plusieurs antennes plasmoniques différentes les unes des autres. Par exemple, ces différentes antennes plasmoniques différent les unes des autres par leurs dimensions.

### Variantes de l'antenne plasmonique :

D'autres métaux peuvent être utilisés en tant que matériau électriquement conducteur pour réaliser l'antenne plasmonique comme par exemple, du cuivre, de l'aluminium ou du cobalt. Des alliages métalliques peuvent également être utilisés comme par exemple AuK. Des nitrures de métaux peuvent aussi être utilisées comme par exemple TiN, ZrN, HfN et leurs formes tertiaires telles que TiZrN, ..., etc.

Le matériau électriquement conducteur utilisé pour réaliser les antennes plasmoniques n'est pas nécessairement un métal. Par exemple, il peut s'agir d'un oxyde conducteur transparent comme par exemple l'indium-étain (ITO) ou du GZO (« Gallium Doped Zinc Oxide ») ou du AZO (« Aluminium Dopez Zinc Oxide ») ..., etc.

Le matériau conducteur peut aussi être un matériau semi-conducteur fortement dopé ou encore un matériau à deux dimensions comme du graphène ou du MoF₂ (« Molybdenum disulfide »).

L'angle β peut être différent de 90°. Par exemple, l'angle β est compris entre 60° et 85°.

Le substrat 8 peut être en métal. Dans ce cas, la couche 10 est réalisée en silice et son épaisseur est par exemple égale à λₘ/2 ou λₘ/4.

D'autres modes de réalisation de l'antenne plasmonique sont encore possibles. Par exemple, les éléments 32 peuvent être formés à l'intérieur de la couche diélectrique et affleurer la face 10. Dans ce cas, les éléments 32 peuvent être fabriqués à l'aide d'un procédé Damascene ou BEOL (« Back End Of Line »). Les éléments 32 peuvent aussi être formés sur l'extrémité de piliers respectifs en matériau diélectrique. Typiquement, dans ce dernier cas, les piliers sont formés dans la couche en matériau diélectrique. Généralement, l'élément 32 recouvre alors l'extrémité horizontale du pilier et au moins une partie des parois verticales du pilier.

### Variantes du procédé de mesure du désalignement :

Dans certains cas particuliers, pour des raisons techniques, l'amplitude Δx ou l'amplitude Δy est systématiquement égale à 0. Dans ces cas, seul l'écart E_{X} ou l'écart E_{Y} est mesuré. De plus, dans le cas où le désalignement ne peut exister que dans une seule direction, l'antenne plasmonique peut aussi être simplifiée. Par exemple, si seule l'amplitude Δx peut prendre une valeur différente de 0, alors les éléments 32c et 32d sont omis et les éléments 32a et 32b sont alignés sur un axe perpendiculaire à la ligne 66. Si au contraire, l'amplitude Δx est systématiquement égale à 0, alors la paire 80 ou la paire 82 peut être omise.

Lorsque le substrat 8 et la couche 10 sont transparents au rayonnement incident polarisé, il est possible de mesurer le taux d'absorption à partir du taux de transmission du rayonnement incident à travers l'antenne plasmonique à la place, ou en plus, de l'utilisation du taux de réflexion. Pour mesurer le taux de transmission de l'antenne plasmonique, le capteur 16 doit être placé du côté du substrat 8 opposé au côté directement exposé au faisceau 6.

En variante, le faisceau 6 éclaire la totalité de la surface du substrat 8 ou une région du substrat 8 contenant des antennes plasmoniques à cheval sur différentes lignes de séparation. La mesure du désalignement se déroule comme précédemment décrit. Toutefois, dans ce cas, le désalignement mesuré est une moyenne des désalignements existants entre les différents champs éclairés par le faisceau 6.

Dans un mode de réalisation simplifié, le sens de désalignement n'est pas déterminé.

S'il n'est pas nécessaire de déterminer l'amplitude du désalignement dans deux directions orthogonales précises et que l'on souhaite simplement obtenir une grandeur représentative de l'amplitude du désalignement sans qu'il soit nécessaire de connaître dans quelle direction se produit se désalignement, alors les taux d'absorption mesurés T₄₅, T-₄₅, T₉₀ et T₀ peuvent être combinés différemment. En particulier, il n'est pas nécessaire de calculer les rapports A_{X} et A_{Y} précédemment décrits. Par exemple, il est possible de déterminer l'amplitude en valeur absolue du désalignement, à partir de la relation (T₄₅² + T₋₄₅²)^{0,5} ou (T₉₀² + T₀²)^{0,5}. Dans ces deux derniers cas, le procédé peut être simplifié en omettant soit les mesures des taux d'absorption T₉₀ et T₀, soit en omettant la mesure des taux d'absorption T₄₅ et T₋₄₅.

La conversion de l'écart Eₓ et/ou E_{y} en nanomètre peut être omise. Par exemple, une telle conversion est inutile pour comparer des mesures entre elles.

Si nécessaire, il est possible de corriger la mesure de l'amplitude Δy à l'aide de l'amplitude Δx mesurée. En effet, les simulations réalisées montre que la mesure de l'amplitude Δx est plus décorrélée de l'amplitude Δy que l'inverse.

En variante, la mesure d'une erreur de dimensionnement est omise. Dans ce cas, il n'est pas nécessaire de réitérer l'étape 114 pour différentes longueurs d'onde λₘᵢ et l'opération 132 est omise.

D'autres modes de réalisation de la mesure d'une erreur de dimensionnement sont possibles. Par exemple, le taux d'absorption de l'antenne est mesuré à une longueur d'onde *λ*₀ à laquelle la résonance des plasmons de surface localisés à l'intérieur du creux 92 ne se produit pas. Le taux d'absorption de l'antenne mesuré à la *λ*₀ longueur d'onde est noté « T_{*λ*0} ». Pour cela, la longueur d'onde *λ*₀ est choisie éloignée de la longueur d'onde *λ*ₘₐₓ. Par exemple, l'écart entre les longueurs d'onde *λ*₀ et *λ*ₘₐₓ est supérieur à 100 nm ou 150 nm ou 200 nm. Le taux T_{*λ*0} est insensible aux erreurs de désalignement. Par contre, ce taux T_{*λ*0} est sensible aux erreurs de dimensionnement d'un ou plusieurs des éléments 32. En particulier, une erreur de dimensionnement qui n'affecte qu'une partie des éléments 32 de l'antenne 60 se traduit par une différence entre le taux T_{*λ*0} et un taux d'absorption normal T_{*λ*0ref}. Le taux T_{*λ*0ref} est le taux d'absorption à la longueur d'onde *λ*₀ de l'antenne en absence d'erreur de dimensionnement. Ce taux T_{*λ*0ref} peut être déterminé par simulations numériques ou mesuré expérimentalement. A l'inverse, en absence d'erreur de dimensionnement, les taux T_{*λ*0} et T_{*λ*0ref} sont sensibles identiques. Dès lors, une erreur de dimensionnement est détectée si la différence entre les taux T_{*λ*0} et T_{*λ*0ref} est supérieure à un seuil prédéterminé. Si la différence entre ces taux T_{*λ*0} et T_{*λ*0ref} est inférieure à ce seuil prédéterminé aucune erreur de dimensionnement n'est détectée. Si une erreur de dimensionnement est détectée, la mesure du désalignement à l'aide de cette antenne peut être interdite par exemple.

Ce qui vient d'être décrit au paragraphe précédent, peut être réalisé pour plusieurs longueurs d'onde distinctes *λ*₀ᵢ auxquelles la résonance des plasmons de surface localisés à l'intérieur du creux 92 ne se produit pas. Ces longueurs d'onde *λ*₀ᵢ peuvent être choisies supérieures ou inférieures à la longueur d'onde *λ*ₘₐₓ.

Le spectre du taux de réflexion ou de transmission de l'antenne 92 peut être mesuré sur une plage de longueurs d'onde contenant non seulement les longueurs d'onde *λ*ₘ et *λ*ₘₐₓ mais aussi la longueur d'onde *λ*₀ ou les longueurs d'onde *λ*₀ᵢ. Pour cela, par exemple, le rayonnement 6 est un rayonnement polychromatique. Dans ce cas, le même spectre mesuré peut être utilisé pour déterminer à la fois une erreur de dimensionnement et une erreur de désalignement.

La mesure d'une erreur de dimensionnement peut être mise en œuvre indépendamment de la mesure du désalignement. Dans ce cas, le procédé de la figure 11 est simplifié. En particulier, les étapes 116, 118 ou 120, 122 peuvent être omises et les étapes 128 et 130 sont omises. Dans le cas où l'on mesure seulement une erreur de dimensionnement, l'antenne 60 n'a pas à être à cheval sur une frontière de séparation entre deux zones de gravure différentes. Par exemple, l'antenne 60 peut dans ce cas être située en plein milieu d'un champ.

### Principaux avantages des modes de réalisation décrits :

L'écart E_{y} varie principalement en fonction de l'amplitude du désalignement dans une direction parallèle à la ligne 66. Par conséquent, cet écart permet de mesurer l'amplitude Δy du désalignement dans une seule direction précise et cela quelle que soit l'amplitude Δx.

Lorsque l'antenne plasmonique codée dans le plan 44 comporte des éléments 32c et 32d qui se déduisent, par rotation, des éléments 32a et 32b, la valeur prédite A_{YP} du rapport A_{y} est simple à calculer et à prédire.

Le fait de mesurer des taux d'absorption pour des rayonnements incidents dont les directions de polarisation sont parallèles, respectivement, aux directions X et Y permet de mesurer en plus l'amplitude Δx.

Lorsque la projection orthogonale, dans le plan du substrat, de l'antenne plasmonique codée par le plan 44 est symétrique par rapport à la ligne 66 et par rapport à un axe horizontal perpendiculaire à cette ligne 66 et si en plus l'axe 84 coupe la ligne 66 avec une inclinaison de 45°, alors la détermination de l'amplitude du désalignement est simplifiée car les valeurs prédites A_{YP} et A_{XP} des rapports A_{y} et Aₓ sont simples à prédire.

Le fait que les éléments 32a à 32d soient des triangles permet d'obtenir une antenne plasmonique pour laquelle la longueur d'onde λₘₐₓ ne varie quasiment pas en fonction des dimensions du creux 92. Ainsi, lors de la mesure du taux d'absorption, il n'est pas nécessaire de faire varier la longueur d'onde λₘ du rayonnement incident en fonction de l'amplitude estimée du désalignement. De plus, ces éléments en forme de triangle forment des antennes bowtie. Avec de telles antennes, il est possible d'atteindre une résolution d'un nanomètre pour la mesure du désalignement. En effet, une modification de quelques nanomètres entraîne une modification importante du taux d'absorption. Dans ce texte, une modification importante du taux d'absorption est une augmentation ou une diminution du taux d'absorption supérieure ou égale à 0,01.Ap et, de préférence, supérieure ou égale à 0,05.Ap ou 0,1.Ap en réponse à une variation d'un nanomètre de la dimension gₓ ou g_{y} par rapport à la même dimension codée dans le plan 44, où Ap est la valeur prédite du taux d'absorption en absence de désalignement.

L'utilisation d'éléments 32 réalisés en matériau conducteur permet d'obtenir des variations du taux d'absorption importantes et donc une très bonne résolution.

Lorsque les éléments 32 sont réalisés en matériau diélectrique ou sont des cavités creusées dans un matériau diélectrique, le procédé de mesure est plus simple à mettre en œuvre car les étapes de gravure d'une couche en matériau conducteur sont omises.

Mesurer le taux d'absorption à une longueur λₘ inférieure à 2000 nm ou 700 nm permet d'atteindre une résolution inférieure ou égale à 2 nm ou 1 nm.

## Revendications

1. Procédé de mesure du désalignement entre une première et une seconde zones de gravure, une zone de gravure étant une zone d'un substrat à l'intérieur de laquelle est gravé un élément ou une partie d'un élément, ce procédé comportant :
- la fourniture (110) d'un plan contenant des instructions codant notamment les dimensions, l'agencement et l'emplacement d'une mire à réaliser, sur un substrat, à cheval entre les première et seconde zones,
- la réalisation (112) de la mire sur le substrat en exécutant les instructions contenues dans le plan fourni et en utilisant une machine de lithographie, puis
- la détermination (128, 130) de l'amplitude du désalignement à partir de l'observation de la mire réalisée sur le substrat,
**caractérisé en ce que** :
- la mire codée par les instructions contenues dans le plan comporte au moins une antenne plasmonique apte, après avoir été réalisée sur le substrat, à produire une résonance des plasmons de surface localisée à l'intérieur d'un creux lorsqu'elle est exposée à un rayonnement incident polarisé de longueur d'onde λₘ de sorte que l'antenne plasmonique absorbe au moins une partie du rayonnement incident polarisé à cette longueur d'onde λₘ, le taux d'absorption de cette antenne plasmonique à la longueur d'onde λₘ variant en fonction d'une dimension du creux, cette antenne plasmonique comportant à cet effet un premier et un deuxième éléments distincts qui délimitent chacun, d'un côté respectif, le creux de sorte que la dimension du creux est fixée par l'espacement entre ces premier et deuxième éléments, ces premier et deuxième éléments étant situés chacun entièrement, respectivement, d'un premier et d'un second côté respectif d'un plan de séparation,
- lors de la réalisation (112) de la mire, tous les éléments de l'antenne plasmonique situés du premier côté du plan de séparation sont entièrement réalisés à l'intérieur de la première zone et tous les éléments de l'antenne plasmonique situés du second côté du plan de séparation sont entièrement réalisés à l'intérieur de la seconde zone,
- après la réalisation de l'antenne plasmonique, le procédé comporte :
• la mesure (114) du taux d'absorption de l'antenne plasmonique réalisée à la longueur d'onde λₘ en exposant cette antenne plasmonique à un rayonnement polarisé incident de longueur d'onde λₘ et d'intensité connue, émis par une source de rayonnement, et en mesurant l'intensité du rayonnement réfléchi par l'antenne plasmonique ou tranmis à travers l'antenne plasmonique à cette même longueur d'onde λₘ à l'aide d'un capteur d'intensité de rayonnement, et
• la détermination (128, 130) de l'amplitude du désalignement entre les première et seconde zones à partir du taux d'absorption mesuré et d'une valeur prédite pour ce taux d'absorption en absence de désalignement entre les première et seconde zones.

2. Procédé selon la revendication 1, dans lequel les instructions contenues dans le plan fourni codent une antenne plasmonique dans laquelle :
- les premier et deuxième éléments sont alignés sur un premier axe d'alignement de manière à ce que le taux d'absorption de l'antenne plasmonique réalisée atteigne un premier maximum lorsqu'elle est exposée à un premier rayonnement incident de longueur d'onde λₘ et de direction de polarisation parallèle à ce premier axe d'alignement, et
- l'antenne plasmonique comporte des troisième et quatrième éléments distincts qui limitent, chacun d'un côté respectif, le même creux ou un autre creux, ces troisième et quatrième éléments étant entièrement situés à l'intérieur, respectivement, des premier et second côtés et ces troisième et quatrième éléments étant alignés sur un deuxième axe d'alignement qui coupe le premier axe d'alignement en un point d'intersection, de sorte que le taux d'absorption de l'antenne plasmonique atteigne un second maximum lorsqu'elle est exposée à un deuxième rayonnement incident de longueur d'onde λₘ et de direction de polarisation parallèle à ce deuxième axe d'alignement,
- la mesure du taux d'absorption comporte :
• une première mesure (116) d'un taux d'absorption Tm1 de l'antenne plasmonique lorsqu'elle est exposée au premier rayonnement incident, et
• une deuxième mesure (118) d'un taux d'absorption Tm2 de l'antenne plasmonique lorsqu'elle est exposée au deuxième rayonnement incident,
- la détermination de l'amplitude du désalignement comporte la détermination (128) de l'amplitude du désalignement entre les première et seconde zones, dans une direction parallèle à une ligne de séparation, cette ligne de séparation étant formée par l'intersection du plan de séparation et du plan du substrat, en fonction de l'écart entre le rapport Tm1/Tm2 et un rapport Tp1/Tp2, où Tp1 et Tp2 sont les valeurs prédites du taux d'absorption, en absence de désalignement, pour, respectivement, les première et la deuxième mesures.

3. Procédé selon la revendication 2, dans lequel, dans le plan fourni, la projection orthogonale dans le plan du substrat de la paire formée par les troisième et quatrième éléments se déduit de la projection orthogonale dans ce même plan de la paire formée par les premier et deuxième éléments, par :
- une rotation dont le centre est situé sur la ligne de séparation, combinée avec
- une translation parallèle à cette ligne de séparation, l'amplitude de cette translation étant supérieure ou égale à zéro.

4. Procédé selon la revendication 3, dans lequel le point d'intersection est situé sur la ligne de séparation.

5. Procédé selon la revendication 4, dans lequel
- la mesure du taux d'absorption comporte :
• une troisième mesure (120) d'un taux d'absorption Am3 de l'antenne plasmonique réalisée lorsqu'elle est exposée à un troisième rayonnement incident de longueur d'onde λₘ et de direction de polarisation parallèle à la bissectrice d'un premier secteur angulaire délimité par les premier et deuxième axes d'alignement,
• une quatrième mesure (122) d'un taux d'absorption Am4 de l'antenne plasmonique réalisée lorsqu'elle est exposée à un quatrième rayonnement incident de longueur d'onde λₘ et de direction de polarisation parallèle à la bissectrice d'un deuxième secteur angulaire délimité par les premier et deuxième axes d'alignement, ce deuxième secteur angulaire présentant un côté commun avec le premier secteur angulaire, et
- la détermination de l'amplitude du désalignement comporte la détermination (130) de l'amplitude du désalignement entre les première et seconde zones dans une direction perpendiculaire à la ligne de séparation en fonction de l'écart entre le rapport Tm3/Tm4 et un rapport Tp3/Tp4, où Tp3 et Tp4 sont les valeurs prédites du taux d'absorption, en absence de désalignement, pour, respectivement, les troisième et quatrième mesures.

6. Procédé selon la revendication 5, dans lequel, dans le plan fourni :
- les projections orthogonales dans le plan du substrat des premier et quatrième éléments sont les symétriques des projections orthogonales, dans le même plan, des deuxième et troisième éléments par rapport à un axe perpendiculaire à la ligne de séparation, et
- les projections orthogonales des premier et troisième éléments dans le plan du substrat sont les symétriques des projections orthogonales des deuxième et quatrième éléments par rapport à la ligne de séparation, et
- la projection orthogonale dans le plan du substrat du premier axe d'alignement coupe la ligne de séparation avec un angle de 45°.

7. Procédé selon l'une quelconque des revendications précédentes, dans lequel, dans le plan fourni, chaque élément comporte une pointe dont le sommet est situé sur un côté respectif du creux, chaque paire d'éléments dont les sommets sont en vis-à-vis et situés sur des côtés respectifs opposés dudit creux, formant ainsi une antenne connue sous le nom de « bowtie ».

8. Procédé selon l'une quelconque des revendications précédentes, dans lequel les éléments sont réalisés dans un matériau électriquement conducteur.

9. Procédé selon l'une quelconque des revendications 1 à 7, dans lequel les éléments sont réalisés en matériau diélectrique et directement déposés sur une couche en matériau électriquement conducteur ou correspondent à des cavités creusées dans une couche en matériau diélectrique directement déposée sur une couche en matériau électriquement conducteur.

10. Procédé selon l'une quelconque des revendications précédentes, dans lequel la longueur d'onde λₘ est inférieure à 2000 nm ou 700 nm.

11. Procédé selon l'une quelconque des revendications précédentes, dans lequel les première et seconde zones sont :
- respectivement, un premier et un second champs, situés dans un même plan parallèle au plan du substrat, d'une machine à lithographie par faisceaux d'électrons, ou
- respectivement, une première et une seconde couches structurées superposées l'une au-dessus de l'autre.

12. Support (26) d'enregistrement d'informations, **caractérisé en ce qu'**il comporte des instructions pour la mise en œuvre d'un procédé de mesure conforme à l'une quelconque des revendications précédentes, lorsque ces instructions sont exécutées par un microprocesseur (24).

13. Appareil de mesure du désalignement entre une première et une seconde zones de gravure pour la mise en œuvre d'un procédé de mesure conforme à l'une quelconque des revendications 1 à 11, cet appareil comportant :
- une source (4) apte à émettre un rayonnement polarisé incident d'intensité connue à une longueur d'onde λₘ sur une antenne plasmonique réalisée sur un substrat,
- un capteur (16) d'intensité de rayonnement apte à mesurer l'intensité du rayonnement réfléchi par l'antenne plasmonique ou transmis à travers l'antenne plasmonique à la longueur d'onde λₘ, et
- un microprocesseur (24) programmé pour déterminer un taux d'absorption à partir de l'intensité connue du rayonnement incident et de l'intensité mesurée du rayonnement réfléchi ou transmis,
**caractérisé en ce que** le microprocesseur (24) est programmé pour déterminer l'amplitude du désalignement entre les première et seconde zones à partir du taux d'absorption mesuré et d'une valeur prédite de ce taux d'absorption en absence de désalignement entre les première et seconde zones.

14. Plan (44) d'une mire pour la mise en œuvre d'un procédé de mesure conforme à l'une quelconque des revendications 1 à 11, ce plan contenant des instructions spécifiques à une machine de lithographie par faisceau d'électrons qui comporte au moins un premier et un second champs distincts, lesdites instructions codant notamment les dimensions, l'agencement et l'emplacement dans les premier et second champs d'au moins une antenne plasmonique à réaliser sur un substrat, cette antenne plasmonique étant apte, après avoir été réalisée sur le substrat, à produire une résonance des plasmons de surface localisée à l'intérieur d'un creux lorsqu'elle est exposée à un rayonnement incident polarisé de longueur d'onde λₘ de sorte que l'antenne plasmonique absorbe au moins une partie du rayonnement incident polarisé à cette longueur d'onde λₘ, le taux d'absorption de cette antenne plasmonique à la longueur d'onde λₘ variant en fonction d'une dimension du creux, cette antenne plasmonique comportant à cet effet un premier et un deuxième éléments distincts qui délimitent chacun, d'un côté respectif, le creux de sorte que la dimension du creux est fixée par l'espacement entre ces premier et deuxième éléments, ces premier et deuxième éléments étant situés chacun entièrement, respectivement, d'un premier et d'un second côté respectif d'un plan de séparation,
**caractérisé en ce que** les dimensions, l'agencement et l'emplacement codés de l'antenne plasmonique sont tels que, tous les éléments de cette antenne plasmonique situés du premier côté du plan de séparation sont entièrement à l'intérieur du premier champ et tous les éléments de l'antenne plasmonique situés du second côté du plan de séparation sont entièrement à l'intérieur du second champ.

## Patentansprüche

1. Verfahren zur Messung des Versatzes zwischen einem ersten und einem zweiten Ätzbereich, wobei ein Ätzbereich ein Bereich eines Substrats ist, in dessen Innerem ein Element oder ein Teil eines Elements geätzt wird, wobei dieses Verfahren umfasst:
- die Bereitstellung (110) eines Plans, der Anweisungen enthält, die insbesondere die Abmessungen, die Anordnung und die Lage eines Testmusters codieren, das auf einem Substrat überlappend zwischen dem ersten und dem zweiten Bereich herzustellen ist,
- die Herstellung (112) des Testmusters auf dem Substrat durch Ausführung der in dem bereitgestellten Plan enthaltenen Anweisungen und unter Verwendung einer Lithografiemaschine, anschließend
- die Bestimmung (128, 130) der Amplitude des Versatzes anhand der Beobachtung des auf dem Substrat hergestellten Testmusters,
**dadurch gekennzeichnet, dass**:
- das durch die in dem Plan enthaltenen Anweisungen codierte Testmuster wenigstens eine plasmonische Antenne umfasst, die geeignet ist, nachdem sie auf dem Substrat hergestellt worden ist, eine im Inneren eines Hohlraums lokalisierte Resonanz der Oberflächenplasmonen zu erzeugen, wenn sie einer polarisierten einfallenden Strahlung mit einer Wellenlänge λₘ ausgesetzt ist, so dass die plasmonische Antenne wenigstens einen Teil der polarisierten einfallenden Strahlung bei dieser Wellenlänge λₘ absorbiert, wobei die Absorptionsrate dieser plasmonischen Antenne bei der Wellenlänge λₘ in Abhängigkeit von einer Abmessung des Hohlraums variiert, wobei diese plasmonische Antenne zu diesem Zweck ein erstes und ein zweites separates Element umfasst, welche jeweils auf einer jeweiligen Seite den Hohlraum begrenzen, so dass die Abmessung des Hohlraums durch den Abstand zwischen diesem ersten und diesem zweiten Element festgelegt ist, wobei dieses erste und dieses zweite Element sich jeweils vollständig auf einer ersten bzw. einer zweiten jeweiligen Seite einer Trennebene befinden,
- bei der Herstellung (112) des Testmusters alle Elemente der plasmonischen Antenne, die sich auf der ersten Seite der Trennebene befinden, vollständig im Inneren des ersten Bereichs hergestellt sind und alle Elemente der plasmonischen Antenne, die sich auf der zweiten Seite der Trennebene befinden, vollständig im Inneren des zweiten Bereichs hergestellt sind,
- nach der Herstellung der plasmonischen Antenne das Verfahren umfasst:
» die Messung (114) der Absorptionsrate der hergestellten plasmonischen Antenne bei der Wellenlänge λₘ, indem diese plasmonische Antenne einer einfallenden polarisierten Strahlung mit der Wellenlänge λₘ und bekannter Intensität ausgesetzt wird, die von einer Strahlungsquelle ausgesendet wird, und indem die Intensität der Strahlung, die bei dieser Wellenlänge λₘ von der plasmonischen Antenne reflektiert oder durch die plasmonische Antenne übertragen wird, mithilfe eines Strahlungsintensitätssensors gemessen wird, und
» die Bestimmung (128, 130) der Amplitude des Versatzes zwischen dem ersten und dem zweiten Bereich aus der gemessenen Absorptionsrate und einem für diese Absorptionsrate vorhergesagten Wert bei Nichtvorhandensein eines Versatzes zwischen dem ersten und dem zweiten Bereich.

2. Verfahren nach Anspruch 1, wobei die in dem bereitgestellten Plan enthaltenen Anweisungen eine plasmonische Antenne codieren, wobei:
- das erste und das zweite Element auf einer ersten Ausrichtungsachse so ausgerichtet sind, dass die Absorptionsrate der hergestellten plasmonischen Antenne ein erstes Maximum erreicht, wenn sie einer ersten einfallenden Strahlung mit der Wellenlänge λₘ und mit einer zu dieser ersten Ausrichtungsachse parallelen Polarisationsrichtung ausgesetzt ist, und
- die plasmonische Antenne ein drittes und ein viertes separates Element umfasst, die jeweils auf einer jeweiligen Seite denselben Hohlraum oder einen anderen Hohlraum begrenzen, wobei dieses dritte und dieses vierte Element sich vollständig im Inneren der ersten bzw. zweiten Seite befinden und dieses dritte und dieses vierte Element auf einer zweiten Ausrichtungsachse, welche die erste Ausrichtungsachse in einem Schnittpunkt schneidet, so ausgerichtet sind, dass die Absorptionsrate der plasmonischen Antenne ein zweites Maximum erreicht, wenn sie einer zweiten einfallenden Strahlung mit der Wellenlänge λₘ und mit einer zu dieser zweiten Ausrichtungsachse parallelen Polarisationsrichtung ausgesetzt ist,
- die Messung der Absorptionsrate umfasst:
• eine erste Messung (116) einer Absorptionsrate Tm1 der plasmonischen Antenne, wenn sie der ersten einfallenden Strahlung ausgesetzt ist, und
• eine zweite Messung (118) einer Absorptionsrate Tm2 der plasmonischen Antenne, wenn sie der zweiten einfallenden Strahlung ausgesetzt ist,
- die Bestimmung der Amplitude des Versatzes die Bestimmung (128) der Amplitude des Versatzes zwischen dem ersten und dem zweiten Bereich in einer zu einer Trennlinie parallelen Richtung, wobei diese Trennlinie durch den Schnitt der Trennebene und der Ebene des Substrats gebildet wird, in Abhängigkeit von der Abweichung zwischen dem Verhältnis Tm1/Tm2 und einem Verhältnis Tp1/Tp2 umfasst, wobei Tp1 und Tp2 die vorhergesagten Werte der Absorptionsrate bei Nichtvorhandensein eines Versatzes für die erste bzw. die zweite Messung sind.

3. Verfahren nach Anspruch 2, wobei in dem bereitgestellten Plan die orthogonale Projektion des von dem dritten und dem vierten Element gebildeten Paares in der Ebene des Substrats sich aus der orthogonalen Projektion des von dem ersten und dem zweiten Element gebildeten Paares in derselben Ebene ableitet durch:
- eine Drehung, deren Mittelpunkt sich auf der Trennlinie befindet, kombiniert mit
- einer Translation parallel zu dieser Trennlinie, wobei die Amplitude dieser Translation größer oder gleich null ist.

4. Verfahren nach Anspruch 3, wobei sich der Schnittpunkt auf der Trennlinie befindet.

5. Verfahren nach Anspruch 4, wobei
- die Messung der Absorptionsrate umfasst:
• eine dritte Messung (120) einer Absorptionsrate Am3 der hergestellten plasmonischen Antenne, wenn sie einer dritten einfallenden Strahlung mit der Wellenlänge λₘ und mit einer Polarisationsrichtung, die zu der Winkelhalbierenden eines von der ersten und der zweiten Ausrichtungsachse begrenzten ersten Winkelsektors parallel ist, ausgesetzt ist,
• eine vierte Messung (122) einer Absorptionsrate Am4 der hergestellten plasmonischen Antenne, wenn sie einer vierten einfallenden Strahlung mit der Wellenlänge λₘ und mit einer Polarisationsrichtung, die zu der Winkelhalbierenden eines von der ersten und der zweiten Ausrichtungsachse begrenzten zweiten Winkelsektors parallel ist, ausgesetzt ist, wobei dieser zweite Winkelsektor eine gemeinsame Seite mit dem ersten Winkelsektor aufweist, und
- die Bestimmung der Amplitude des Versatzes die Bestimmung (130) der Amplitude des Versatzes zwischen dem ersten und dem zweiten Bereich in einer zu der Trennlinie senkrechten Richtung in Abhängigkeit von der Abweichung zwischen dem Verhältnis Tm3/Tm4 und einem Verhältnis Tp3/Tp4 umfasst, wobei Tp3 und Tp4 die vorhergesagten Werte der Absorptionsrate bei Nichtvorhandensein eines Versatzes für die dritte bzw. die vierte Messung sind.

6. Verfahren nach Anspruch 5, wobei in dem bereitgestellten Plan:
- die orthogonalen Projektionen des ersten und des vierten Elements in der Ebene des Substrats symmetrisch zu den orthogonalen Projektionen des zweiten und des dritten Elements in derselben Ebene bezüglich einer zu der Trennlinie senkrechten Achse sind, und
- die orthogonalen Projektionen des ersten und des dritten Elements in der Ebene des Substrats symmetrisch zu den orthogonalen Projektionen des zweiten und des vierten Elements bezüglich der Trennlinie sind, und
- die orthogonale Projektion der ersten Ausrichtungsachse in der Ebene des Substrats die Trennlinie unter einem Winkel von 45° schneidet.

7. Verfahren nach einem der vorhergehenden Ansprüche, wobei in dem bereitgestellten Plan jedes Element eine Spitze umfasst, deren Scheitelpunkt sich auf einer jeweiligen Seite des Hohlraums befindet, wobei jedes Paar von Elementen, deren Scheitelpunkte einander gegenüberliegen und sich auf entgegengesetzten jeweiligen Seiten des Hohlraums befinden, somit eine unter der Bezeichnung "Bowtie-Antenne" bekannte Antenne bildet.

8. Verfahren nach einem der vorhergehenden Ansprüche, wobei die Elemente aus einem elektrisch leitenden Material hergestellt werden.

9. Verfahren nach einem der Ansprüche 1 bis 7, wobei die Elemente aus dielektrischem Material hergestellt und direkt auf eine Schicht aus elektrisch leitendem Material aufgebracht werden oder Hohlräumen entsprechen, die in einer Schicht aus dielektrischem Material ausgebildet werden, die direkt auf eine Schicht aus elektrisch leitendem Material aufgebracht wird.

10. Verfahren nach einem der vorhergehenden Ansprüche, wobei die Wellenlänge λₘ kleiner als 2000 nm oder 700 nm ist.

11. Verfahren nach einem der vorhergehenden Ansprüche, wobei der erste und der zweite Bereich:
- ein erstes bzw. ein zweites Feld einer Elektronenstrahllithografie-Maschine sind, die sich in derselben, zur Ebene des Substrats parallelen Ebene befinden,
oder
- eine erste bzw. eine zweite strukturierte Schicht sind, die einander überlagert sind.

12. Informationsaufzeichnungsmedium (26), **dadurch gekennzeichnet, dass** es Anweisungen zur Durchführung eines Messverfahrens gemäß einem der vorhergehenden Ansprüche, wenn diese Anweisungen von einem Mikroprozessor (24) ausgeführt werden, umfasst.

13. Vorrichtung zur Messung des Versatzes zwischen einem ersten und einem zweiten Ätzbereich zur Durchführung eines Messverfahrens gemäß einem der Ansprüche 1 bis 11, wobei diese Vorrichtung umfasst:
- eine Quelle (4), die geeignet ist, eine einfallende polarisierte Strahlung mit bekannter Intensität bei einer Wellenlänge λₘ auf eine plasmonische Antenne zu senden, die auf einem Substrat hergestellt ist,
- einen Strahlungsintensitätssensor (16), der geeignet ist, die Intensität der Strahlung zu messen, die bei der Wellenlänge λₘ von der plasmonischen Antenne reflektiert oder durch die plasmonische Antenne übertragen wird, und
- einen Mikroprozessor (24), der dafür programmiert ist, aus der bekannten Intensität der einfallenden Strahlung und der gemessenen Intensität der reflektierten oder übertragenen Strahlung eine Absorptionsrate zu bestimmen,
**dadurch gekennzeichnet, dass** der Mikroprozessor (24) dafür programmiert ist, die Amplitude des Versatzes zwischen dem ersten und dem zweiten Bereich aus der gemessenen Absorptionsrate und einem vorhergesagten Wert dieser Absorptionsrate bei Nichtvorhandensein eines Versatzes zwischen dem ersten und dem zweiten Bereich zu bestimmen.

14. Plan (44) eines Testmusters zur Durchführung eines Messverfahrens gemäß einem der Ansprüche 1 bis 11, wobei dieser Plan Anweisungen enthält, die für eine Elektronenstrahllithografie-Maschine spezifisch sind, welche wenigstens ein erstes und ein zweites separates Feld aufweist, wobei die Anweisungen insbesondere die Abmessungen, die Anordnung und die Lage wenigstens einer auf einem Substrat herzustellenden plasmonischen Antenne in dem ersten und dem zweiten Feld codieren, wobei diese plasmonische Antenne geeignet ist, nachdem sie auf dem Substrat hergestellt worden ist, eine im Inneren eines Hohlraums lokalisierte Resonanz der Oberflächenplasmonen zu erzeugen, wenn sie einer polarisierten einfallenden Strahlung mit einer Wellenlänge λₘ ausgesetzt ist, so dass die plasmonische Antenne wenigstens einen Teil der polarisierten einfallenden Strahlung bei dieser Wellenlänge λₘ absorbiert, wobei die Absorptionsrate dieser plasmonischen Antenne bei der Wellenlänge λₘ in Abhängigkeit von einer Abmessung des Hohlraums variiert, wobei diese plasmonische Antenne zu diesem Zweck ein erstes und ein zweites separates Element umfasst, welche jeweils auf einer jeweiligen Seite den Hohlraum begrenzen, so dass die Abmessung des Hohlraums durch den Abstand zwischen diesem ersten und diesem zweiten Element festgelegt ist, wobei dieses erste und dieses zweite Element sich jeweils vollständig auf einer ersten bzw. einer zweiten jeweiligen Seite einer Trennebene befinden,
**dadurch gekennzeichnet, dass** die Abmessungen, die Anordnung und die Lage der plasmonischen Antenne, die codiert sind, so beschaffen sind, dass alle Elemente dieser plasmonischen Antenne, die sich auf der ersten Seite der Trennebene befinden, vollständig im Inneren des ersten Feldes sind und alle Elemente der plasmonischen Antenne, die sich auf der zweiten Seite der Trennebene befinden, vollständig im Inneren des zweiten Feldes sind.

## Claims

1. Method for measuring the misalignment between first and second etching zones, an etching zone being a zone of a substrate inside of which an element or one portion of an element is etched, this method comprising:
- providing (110) a plan containing instructions in particular coding the dimensions, arrangement and location of a marker to be produced, on a substrate, straddling the first and second zones,
- producing (112) the marker on the substrate by executing the instructions contained in the provided plan and using a lithography machine, then
- determining (128, 130) the amplitude of the misalignment on the basis of observation of the marker produced on the substrate,
**characterized in that**:
- the marker coded by the instructions contained in the plan comprises at least one plasmonic antenna able, after having been produced on the substrate, to produce surface plasmon resonance localized to the interior of a recess when it is exposed to polarized incident radiation of wavelength λₘ so that the plasmonic antenna absorbs at least some of the polarized incident radiation at this wavelength λₘ, the absorption coefficient of this plasmonic antenna at the wavelength λₘ varying as a function of a dimension of the recess, this plasmonic antenna comprising to this end first and second distinct elements that each bound, on a respective side, the recess so that the dimension of the recess is set by the spacing between these first and second elements, these first and second elements each being entirely located on a first and a second respective side of a plane of separation, respectively,
- during the production (112) of the marker, all the elements of the plasmonic antenna that are located on the first side of the plane of separation are entirely produced in the interior of the first zone and all the elements of the plasmonic antenna that are located on the second side of the plane of separation are entirely produced in the interior of the second zone,
- after the production of the plasmonic antenna, the method comprises:
• measuring (114) the absorption coefficient of the produced plasmonic antenna at the wavelength λₘ by exposing this plasmonic antenna to incident polarized radiation of wavelength λₘ and of known intensity, emitted by a radiation source, and by measuring the intensity of the radiation reflected by the plasmonic antenna or transmitted through the plasmonic antenna at the same wavelength λₘ using a radiation-intensity sensor, and
• determining (128, 130) the amplitude of the misalignment between the first and second zones on the basis of the measured absorption coefficient and of a value predicted for this absorption coefficient in the absence of misalignment between the first and second zones.

2. Method according to Claim 1, wherein the instructions contained in the provided plan code a plasmonic antenna in which:
- the first and second elements are aligned on a first axis of alignment so that the absorption coefficient of the produced plasmonic antenna reaches a first maximum when it is exposed to first incident radiation of wavelength λₘ and of polarization direction parallel to this first axis of alignment, and
- the plasmonic antenna comprises third and fourth distinct elements that limit, each on one respective side, the same recess or another recess, these third and fourth elements being entirely located in the interior of the first and second sides, respectively, and these third and fourth elements being aligned on a second axis of alignment that cuts the first axis of alignment at a point of intersection, so that the absorption coefficient of the plasmonic antenna reaches a second maximum when it is exposed to second incident radiation of wavelength λₘ and of polarization direction parallel to this second axis of alignment,
- the measurement of the absorption coefficient comprises:
• a first measurement (116) of an absorption coefficient Tm1 of the plasmonic antenna when it is exposed to the first incident radiation, and
• a second measurement (118) of an absorption coefficient Tm2 of the plasmonic antenna when it is exposed to the second incident radiation,
- the determination of the amplitude of the misalignment comprises determining (128) the amplitude of the misalignment between the first and second zones, in a direction parallel to a line of separation, this line of separation being formed by the intersection of the plane of separation and of the plane of the substrate, depending on the discrepancy between the ratio Tm1/Tm2 and a ratio Tp1/Tp2, where Tp1 and Tp2 are the values of the absorption coefficient, in the absence of misalignment, predicted for the first and second measurements, respectively.

3. Method according to Claim 2, wherein, in the provided plan, the orthogonal projection in the plane of the substrate of the pair formed by the third and fourth elements is deduced from the orthogonal projection in the same plane of the pair formed by the first and second elements, via:
- a rotation the centre of which is located on the line of separation, combined with
- a translation parallel to this line of separation, the amplitude of this translation being higher than or equal to zero.

4. Method according to Claim 3, wherein the point of intersection is located on the line of separation.

5. Method according to Claim 4, wherein
- the measurement of the absorption coefficient comprises:
• a third measurement (120) of an absorption coefficient Am3 of the produced plasmonic antenna when it is exposed to third incident radiation of wavelength λₘ and of polarization direction parallel to the bisector of a first angular sector bounded by the first and second axes of alignment,
• a fourth measurement (122) of an absorption coefficient Am4 of the produced plasmonic antenna when it is exposed to fourth incident radiation of wavelength λₘ and of polarization direction parallel to the bisector of a second angular sector bounded by the first and second axes of alignment, this second angular sector having a side in common with the first angular sector, and
- the determination of the amplitude of the misalignment comprises determining (130) the amplitude of the misalignment between the first and second zones, in a direction perpendicular to the line of separation depending on the discrepancy between the ratio Tm3/Tm4 and a ratio Tp3/Tp4, where Tp3 and Tp4 are the values of the absorption coefficient, in the absence of misalignment, predicted for the third and fourth measurements, respectively.

6. Method according to Claim 5, wherein, in the provided plan:
- the orthogonal projections in the plane of the substrate of the first and fourth elements are symmetrical to the orthogonal projections, in the same plane, of the second and third elements with respect to an axis perpendicular to the line of separation, and
- the orthogonal projections of the first and third elements in the plane of the substrate are symmetrical to the orthogonal projections of the second and fourth elements with respect to the line of separation, and
- the orthogonal projection in the plane of the substrate of the first axis of alignment cuts the line of separation with an angle of 45°.

7. Method according to any one of the preceding claims, wherein, in the provided plan, each element comprises a tip the apex of which is located on one respective side of the recess, each pair of elements the apexes of which are facing each other and located on opposite respective sides of said recess thus forming what is known as a bowtie antenna.

8. Method according to any one of the preceding claims, wherein the elements are made from an electrically conductive material.

9. Method according to any one of Claims 1 to 7, wherein the elements are made from dielectric material and deposited directly on a layer made of electrically conductive material or correspond to cavities recessed in a layer made of dielectric material deposited directly on a layer made of electrically conductive material.

10. Method according to any one of the preceding claims, wherein the wavelength λₘ is shorter than 2000 nm or 700 nm.

11. Method according to any one of the preceding claims, wherein the first and second zones are:
- a first field and a second field of an electron-beam lithography machine, respectively, said fields being located in the same plane parallel to the plane of the substrate, or
- a first structured layer and a second structured layer, respectively, said layers being superposed one on top of the other.

12. Data storage medium (26) **characterized in that** it comprises instructions for implementing a measuring method according to any one of the preceding claims, when these instructions are executed by a microprocessor (24).

13. Apparatus for measuring the misalignment between first and second etching zones for implementing a measuring method according to any one of Claims 1 to 11, this apparatus comprising:
- a source (4) able to emit polarized incident radiation of known intensity at a wavelength λₘ onto a plasmonic antenna produced on a substrate,
- a radiation-intensity sensor (16) able to measure the intensity of the radiation reflected by the plasmonic antenna or transmitted through the plasmonic antenna at the wavelength λₘ, and
- a microprocessor (24) programmed to determine an absorption coefficient on the basis of the known intensity of the incident radiation and of the measured intensity of the reflected or transmitted radiation,
**characterized in that** the microprocessor (24) is programmed to determine the amplitude of the misalignment between the first and second zones on the basis of the measured absorption coefficient and of a value predicted for this absorption coefficient in the absence of misalignment between the first and second zones.

14. Plan (44) of a marker for implementing a measuring method according to any one of Claims 1 to 11, this plan containing instructions specific to an electron-beam lithography machine that comprises at least a first and a second distinct field, said instructions in particular coding the dimensions, the arrangement and the location in the first and second fields of at least one plasmonic antenna to be produced on a substrate, this plasmonic antenna being able, after having been produced on the substrate, to produce surface plasmon resonance localized to the interior of a recess when it is exposed to polarized incident radiation of wavelength λₘ so that the plasmonic antenna absorbs at least some of the polarized incident radiation at this wavelength λₘ, the absorption coefficient of this plasmonic antenna at the wavelength λₘ varying as a function of a dimension of the recess, this plasmonic antenna comprising to this end first and second distinct elements that each bound, on a respective side, the recess so that the dimension of the recess is set by the spacing between these first and second elements, these first and second elements each being entirely located on a first and a second respective side of a plane of separation, respectively,
**characterized in that** the coded dimensions, arrangement and location of the plasmonic antenna are such that all the elements of this plasmonic antenna that are located on the first side of the plane of separation are entirely in the interior of the first field and all the elements of the plasmonic antenna that are located on the second side of the plane of separation are entirely in the interior of the second field.
